# EUROPÄISCHE PATENTSCHRIFT

(11) **EP 0 521 338 B1**
(45) Veröffentlichungstag und Bekanntmachung des Hinweises auf die Patenterteilung: **14.09.1994**
(21) Anmeldenummer: 92110139.0
(22) Anmeldetag: 16.06.1992
(51) Int. Cl.: H05K 13/04

(54) **Verfahren und Anordnung zum Auflöten von oberflächenbefestigbaren Bausteinen auf Leiterplatten**
Method and arrangement for soldering surface mounted components on printed circuit boards
Méthode et dispositif pour souder des composants à monter en surface sur des plaques de circuits imprimés

(30) Priorität: 26.06.1991 DE 4121107
(43) Veröffentlichungstag der Anmeldung: 07.01.1993
(73) Patentinhaber: Siemens Nixdorf Informationssysteme Aktiengesellschaft, 33102 Paderborn (DE)
(72) Erfinder: Schweizer, Matthias, W-8894 Igenhausen (DE); Derleth, Horst, W-8901 Diedorf (DE)
(74) Vertreter: Fuchs, Franz-Josef, Dr.-Ing.

(56) Entgegenhaltungen:
- EP-A- 0 341 629
- DE-U- 8 531 940
- US-A- 4 552 300
- US-A- 5 003 692

## Beschreibung

Die Erfindung betrifft ein Verfahren und eine Anordnung zum Auflöten von oberflächenbefestigbaren Bausteinen auf Leiterplatten.

Es ist bekannt bei Outerleadabständen von > 150µm, das Outerleadbonding mit Hilfe zweier getrennter Systeme, einem Positionier- und einem Lötsystem durchzuführen. Der Baustein wird nach dem Plazieren vom Positionssystem losgelassen, ist also bei Beginn des Lötvorgangs auf den Einbauplatz nicht fixiert und wird beim Löten verschoben, d.h. die Outerleads (Außenanschlußkontakte) werden nicht lagerichtig gelötet und müssen korrigiert werden. Dabei wird im Allgemeinen das Bügellöten eingesetzt, wobei durch Heften der Eckleads vor dem Bügellöten Abhilfe geschaffen werden kann. Bei Outerleadabständen < 150µm wird im Allgemeinen vom Bügellöten Abstand genommen und zum größten Teil Einzelleadlötung, bevorzugt mit Lötspitzen oder Laser, eingesetzt. Dieses Verfahren ist jedoch sehr zeitaufwendig und läßt sich schwer automatisieren. Auch das Problem des genauen Plazierens ist damit nicht gelöst.

Aufgabe der vorliegenden Erfindung ist es, ein Verfahren und eine Anordnung zum Auflöten von oberflächenbefestigbaren Bausteinen auf Leiterplatten anzugeben, durch das vielpolige Mikrobausteine mit Außenanschlußkontaktabständen (kleiner 150µm) in einem Arbeitsgang lagerichtig auf die zugehörigen Lötflecken einer Leiterplatte auflötbar sind.

Gemäß der Erfindung Laut Anspruch 1 wird dabei so verfahren, daß eine Thermode lagerichtig auf eine Biegesenke, auf der die Außenanschlüsse der Bausteine gebogen und geschnitten werden, abgesenkt wird und solange über den aufzulötenden Baustein verharrt, bis eine Saugpipette mit anlegbaren Vakuum auf die Oberfläche des Bausteins abgesenkt und der Baustein angesaugt wird, daß die Lage der Außenanschlüsse des Bausteins zu den Lötbügeln der Thermode optisch kontrolliert und wenn nötig korrigiert und durch Anheben der Pipette aus der Biegesenke entnommen, dem Einbauplatz auf der jeweiligen Leiterplatte zugeführt und dort so weit abgesenkt wird, daß die Außenanschlüsse des Bausteins die zugehörigen Lötflecken auf der Leiterplatte gerade noch nicht berühren, daß dann die Optik bis in unmittelbare Nähe der Lötstelle eingefahren und die Lagegenauigkeit der Außenanschlüsse der Bausteine zu den Lötflecken der Leiterplatte kontrolliert und wenn erforderlich korrigiert wird, daß anschließend die Optik ausgefahren und die Thermode abgesenkt wird, bis die Außenanschlüsse des Bausteins auf dem Lötflecken der Leiterplatte aufliegen, daß danach das Vakuum von der Saugpipette getrennt und diese ein Stück nach oben verschoben und gleichzeitig mit dem nun beginnenden Lötvorgang Stickstoff aus der Pipette auf die Lötstelle aufgeblasen wird und daß nach dem Lötvorgang die Thermode und die Pipette wieder in Endstellung gebracht werden.

Die Anordnung zur Durchführung des Verfahrens sieht dabei erfindungsgemäß Laut Anspruch 2 vor, daß eine erste Lineareinheit mit einer Schneckentriebwelle zum Ausführen von Vertikalbewegungen mit einem ersten Schrittmotor gekoppelt ist, der seinerseits über eine Säule, welche stirnseitig eine Druckfeder führt, eine an der ersten Lineareinheit befestigte Thermode vertikal bewegt, daß die Thermode im Viereck angeordnete und einzeln temperaturgeregelte Lötbügel enthält, daß an einer zweiten Lineareinheit eine Saugpipette befestigt ist, die mittels eines zweiten Schrittmotors zwischen den Lötbügeln der Thermode verschiebbar angeordnet ist und daß seitlich an der Thermode eine horizontal ausfahrbare Optik angeordnet ist.

Durch das Annähern der Thermode in das Biegegesenk beim Abholen des geschnittenen und gebogenen Bausteins ist sichergestellt, daß sich die ausgeformten und durch Stege stabilisierten Außenanschlußkontakte (Outerleads) im Bereich der Lötbügel befinden.

Das Justieren des oberflächenbefestigbaren Bausteins, z.B. eines Mikropacks, d.h. das lagerichtige Zuordnen der Outerleads auf die Lötflecken (Pads) auf den zugehörigen Leiterplatten erfolgt über eine einschiebbare Optik an den vier Ecken des Outerleadbereichs, wobei jede Ausrichtungsbewegung des Bausteins mit der Pipette bedingt durch die vorstehend angegebene Lötkopfkonstruktion auch gleichzeitig von der Thermode durchgeführt wird. Die verschiebbare Optik kann dabei gleichzeitig als ein Bestandteil zur Automatisierung mit Bildverarbeitung verwendet werden. Durch die Einzelregelung der einzelnen Lötbügel der Thermode wird eine umlaufend gleichmäßige Temperatur beim Lötvorgang und damit eine hohe Lötqualität erreicht. Zur weiteren Verbesserung der Lötqualität trägt bei, daß während des Lötvorgangs durch die Saugbohrungen der Pipette Stickstoff geblasen wird.

Anhand der Skizzen nach Figur 1, sowie der Ausführungsbeispiele nach den Figuren 2 und 3 wird die Erfindung näher erläutert.

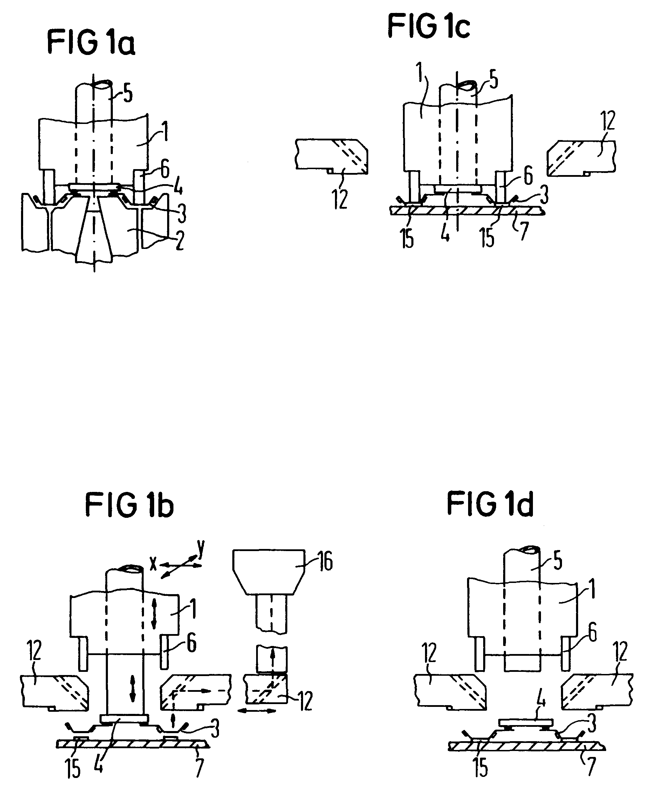

Es zeigen
- FIG 1: das Aufnehmen des Bauteils und das Löten in vier Verfahrensschritten,

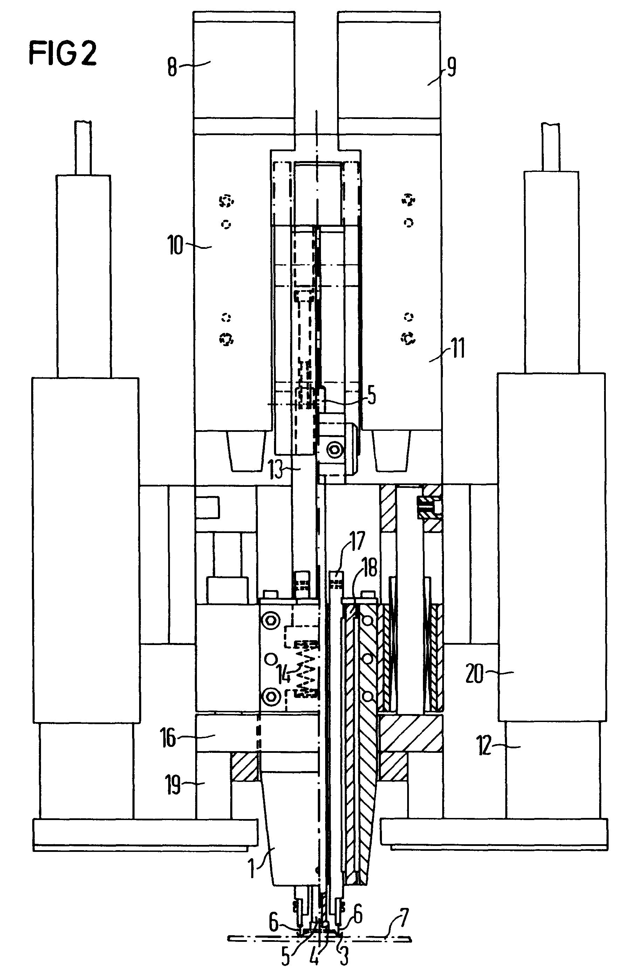

- FIG 2: die Vorderansicht des Lötkopfes mit Thermode und Pipette,

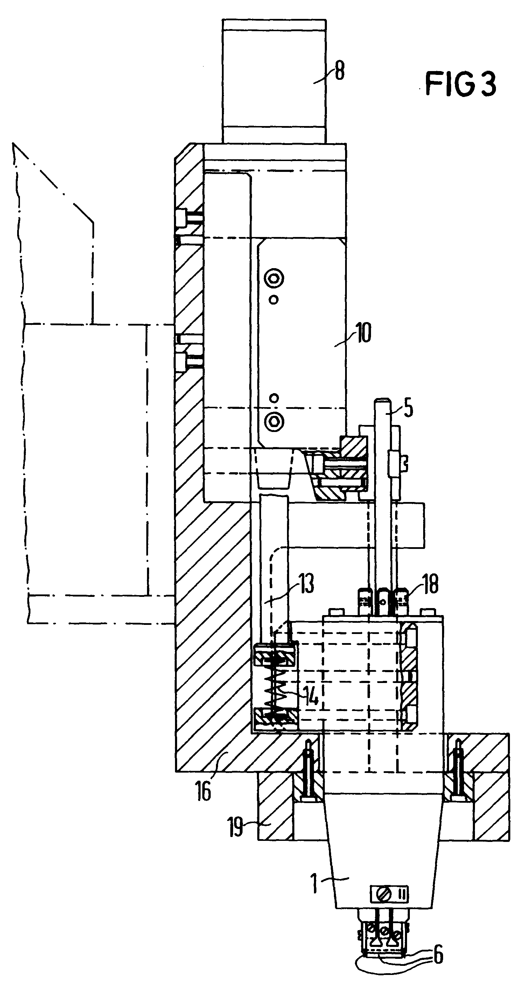

- FIG 3: die Seitenansicht des Lötkopfes.

In FIG 1a ist der erste Verfahrensschritt dargestellt. Die Thermode 1, die ein Lötsystem mit vier getrennten einzel regelbaren Lötbügeln 6 darstellt, wird in vertikaler Richtung bewegt. Sie senkt sich beim lagerichtigen Abholen des beschnittenen und gebogenen Bausteins 4 in das Biegegesenk 2 und verharrt, bis sich die Saugpipette 5 auf die Bausteinoberkante abgesenkt hat. Das Vakuum wird zugeschaltet und der Baustein 4 angesaugt und gemeinsam mit der Thermode 1 aus dem Biegeunterteil entnommen. Die späteren Sollötstellen sind also bereits zu den Lötbügeln 6 ausgerichtet. Durch das optische System 12 ist eine Kontrolle der Outerleadstellung möglich.

Das Justieren des Bausteins 4 zum Einbauplatz, d.h. der Outerleads 3 auf die Lötflecken (Pads) 15 der Leiterplatte 7 erfolgt wie in FIG 1b dargestellt über die einschiebbare Optik 12 an den vier Ecken des Outerleadbereichs. Die Pipette 5 senkt hierzu den Baustein auf ca. 100µm über die Leiterplatte ab. Jede Ausrichtbewegung des Bausteins 4 mit der Pipette 5 wird bedingt durch die Lötkopfkonstruktion auch von der Thermode 1 durchgeführt. Eventuell notwendige Drehbewegungen werden mit dem Auflagetisch für die Leiterplatte durchgeführt. Dabei entstehende Abweichungen in der xy-Ebene, werden automatisch durch das Lötsystem korrigiert. Optisch erfaßt werden ca. 18 Outerleads an jeder Bausteinecke. Sind die Leads, beobachtbar über Monitore 16, deckungsgleich über den Pads, wird der Baustein 4 mittels weiterem Absenken der Pipette 5 auf die Leiterplatte abgesetzt, wie in FIG 1c dargestellt. Eine optische Kontrolle bzw. eine nochmalige Korrektur ist dabei weiterhin möglich. Ist die Plazierung in Ordnung, fährt die Optik 12 in Ausgangsstellung und die Thermode 1 senkt sich auf die auf den Pads 15 liegenden Outerleads 3 des Bausteins 4. Während der Lötphase wird das Vakuum in der Pipette 5 abgeschaltet. Sie bewegt sich ca. 5 mm nach oben und durch die Ansaugöffnung wird Stickstoff auf die Lötstellen geblasen, um eine bessere Meniskenbildung zu erreichen. Gleichzeitig dient der Stickstoff auch zur Kühlung des Innerlead-Bereichs.

Eine nochmalige Kontrolle der richtigen Plazierung, bzw. des Lötergebnisses, schließt den Verfahrensvorgang, wie in FIG 1b dargestellt, ab.

Die Vorderansicht des gesamten Lötkopfes mit Thermode 1 und Pipette 5 ist in FIG 2 dargestellt. Der Lötkopf besteht aus einer ersten Lineareinheit 10, die in ihrem Inneren eine Schneckentriebwelle aufweist und einer gleich ausgebildeten zweiten Lineareinheit 11. Die erste Lineareinheit wird vom ersten Schrittmotor 8 und die zweite Lineareinheit vom zweiten Schrittmotor 9 angetrieben, wobei die Rotationsbewegung der Schrittmotoren über die Schneckenwelle (nicht dargestellt) in eine vertikale Bewegung umgesetzt werden. Beide Lineareinheiten 10, 11 sind unabhängig voneinander bewegbar. An der ersten Lineareinheit 10 ist über eine Säule 13, welche stirnseitig eine Druckfeder 14 führt, die Thermode 1 federnd befestigt. Die Kraftübertragung erfolgt mittels der Säule 13 und der Druckfeder 14. Die Lötkräfte hängen von der Federkonstanten, dem Thermodengewicht und den Verfahrenswegen des ersten Schrittmotors 8 ab. An der zweiten Lineareinheit 11 ist die Pipette 5 angebracht und damit unabhängig von der Thermode 1 ebenfalls vertikal bewegbar. Die Pipette 5 ist so angeordnet, daß sie sich im Zentrum des von den vier Lötbügeln 6 der Thermode 1 gebildeten Vierecks befindet. Die Pipette 5 ist damit, unabhängig von der Thermode 1, relativ zu dieser vertikal bewegbar. Beide Lineareinheiten 10, 11 sind jedoch in der Horizontalen konstruktiv durch das Befestigungsteil 16 starr verbunden, so daß jede Ausrichtungsbewegung des Bausteins 4 mit der Pipette 5 auch von der Thermode 1 durchgeführt wird - wie bereits vorstehend erläutert -. Die Zuführung der Spannung erfolgt über die Lötbügelhalter 17 (positive Spannung) und dem Thermodenaußenkörper 18. Die Optik 12 enthält außerdem eine Ringleuchte 19, die rund um die Thermode angeordnet ist. Die Optik 12 ist über den Pneumatikzylinder 20 ausfahrbar, außerdem führt eine TV-Sonde im Inneren des Zylinders von der Optik zu den nicht dargestellten Monitoren, an denen die Genauigkeit der Positionierung beobachtet werden kann. Die Pipette 5 ist dabei im Ansaugzustand dargestellt.

## Patentansprüche

1. Verfahren zum Auflöten von oberflächenbefestigbaren Bausteinen auf Leiterplatten,
**dadurch gekennzeichnet**, daß eine Thermode (1) lagerichtig auf eine Biegesenke (2) auf der die Aussenanschlüsse (3) der Bausteine (4) gebogen und geschnitten worden sind, abgesenkt wird und solange über den aufzulötenden Baustein (4) verharrt, bis eine Saugpipette (5) mit anlegbaren Vakuum auf die Oberfläche des Bausteins (4) abgesenkt und der Baustein (4) angesaugt wird, daß die Lage der Außenanschlüsse (3) des Bausteins (4) zu den Lötbügeln (6) der Thermode (1) optisch kontrolliert und wenn nötig korrigiert wird und der Baustein durch Anheben der Saugpipette (5) aus der Biegesenke (2) entnommen, dem Einbauplatz auf der jeweiligen Leiterplatte (7) zugeführt und dort abgesenkt wird, daß die Außenanschlüsse des Bausteins (4) die zugehörigen Lötflecken (15) auf der Leiterplatte (7) gerade noch nicht berühren, daß dann die Optik (12) bis in unmittelbare Nähe der Lötstelle eingefahren und die Lagegenauigkeit der Außenanschlüsse (3) der Bausteine (4) zu den Lötflecken (15) der Leiterplatte (7) kontrolliert und wenn erforderlich korrigiert wird, daß anschließend die Optik (12) ausgefahren und die Thermode (1) abgesenkt wird bis die Außenanschlüsse (3) des Bausteins (4) auf dem Lötflecken der Leiterplatte (7) aufliegen, daß danach das Vakuum von der Saugpipette (5) getrennt und diese ein Stück nach oben verschoben und gleichzeitig mit dem nun beginnenden Lötvorgang Stickstoff aus der Saugpipette (5) auf die Lötstelle aufgeblasen wird und daß nach dem Lötvorgang die Thermode (1) und die Saugpipette (5) wieder in Endstellung gebracht werden.

2. Anordnung zur Durchführung des Verfahrens nach Anspruch 1, **dadurch gekennzeichnet**, daß eine erste Lineareinheit (10) mit einer Schneckentriebwelle zum Ausführen von Vertikalbewegungen mit einem ersten Schrittmotor (8) gekoppelt ist, der seinerseits über eine Säule (13), welche stirnseitig eine Druckfeder (14) führt, eine an der ersten Lineareinheit (10) befestigte Thermode (1) vertikal bewegt, daß die Thermode (1) im Viereck angeordnete und einzeln temperaturgeregelte Lötbügel (6) enthält, daß an einer zweiten Lineareinheit (11) eine Saugpipette (5) befestigt ist, die mittels eines zweiten Schrittmotors (9) zwischen den Lötbügeln der Thermode (1) vertikal verschiebbar angeordnet ist und daß seitlich an der Thermode (1) eine horizontal ausfahrbare Optik (12) angeordnet ist.

## Claims

1. Method for soldering surface mounted devices onto printed circuit boards, characterized in that a thermode (1) is lowered in the correct position onto a bending die (2) on which the external connections (3) of the devices (4) have been bent and cut and is kept over the device (4) which is to be soldered on until a suction pipette (5) having an appliable vacuum is lowered onto the surface of the device (4) and the device (4) is sucked on, in that the position of the external connections (3) of the device (4) with respect to the soldering irons (2) of the thermode (1) is monitored visually and is corrected if necessary, and the device is removed from the bending die (2) by lifting the suction pipette (5), is fed to the installation location on the respective printed circuit board (7) and is lowered there, in that the external connections of the device (4) just do not yet touch the associated solder lands (15) on the printed circuit board (7), in that the optics (12) are then moved into the immediate vicinity of the soldering point and the positioning accuracy of the external connections (3) of the devices (4) with respect to the solder lands (15) on the printed circuit board (7) is monitored and is corrected if necessary, in that the optics (12) are subsequently moved away and the thermode (1) is lowered until the external connections (3) of the device (4) rest on the solder lands on the printed circuit board (7), in that, after this, the vacuum is disconnected from the suction pipette (5) and the latter is moved slightly upwards and, simultaneously with the soldering process which is now starting, nitrogen is blown out of the suction pipette (5) onto the soldering point, and in that the thermode (1) and the suction pipette (5) are moved into the limit position again after the soldering process.

2. Arrangement for carrying out the method according to Claim 1, characterized in that a first linear unit (10) having a worm drive shaft for carrying out vertical movements is coupled to a first stepping motor (8) which, for its part, moves a thermode (1), which is mounted on the first linear unit (10), vertically via a column (13) which guides a compression spring (14) at the end, in that the thermode (1) contains soldering irons (6) which are arranged in a quadrilateral shape and whose temperature is regulated individually, in that a suction pipette (5) is mounted on a second linear unit (11) and is arranged such that it can be displaced vertically, by means of a second stepping motor (9), between the soldering irons of the thermode (1), and in that optics (12) which can be moved away horizontally are arranged laterally on the thermode (1).

## Revendications

1. Procédé pour fixer par brasage des modules, pouvant être fixés en surface, sur des plaquettes à circuits imprimés,
caractérisé par le fait qu'on abaisse une unité thermique de brasage (1) en bonne position sur une matrice de coudage (2), sur laquelle les bornes extérieures (3) des modules (4) sont coudés et sectionnés, et on maintient ladite unité sur le module (4) devant être fixé par brasage, jusqu'à ce qu'une pipette d'aspiration (5), dans laquelle peut être créé un vide, soit abaissée sur la surface du module (4) et que le module (4) soit aspiré, que la position des bornes extérieures (3) du module (4) par rapport aux étriers de brasage (6) de l'unité thermique de brasage (1) est commandée optiquement et, lorsque cela est nécessaire, est corrigée et que sous l'effet du soulèvement de la pipette d'aspiration (5), le module est retiré de la matrice de pliage (2), est amené à l'emplacement de montage sur sa plaquette à circuits imprimés (7) et y est abaissé, que les bornes extérieures du module (4) ne touchent précisément pas encore les plots de brasure associés (15) sur la plaquette à circuits imprimés, qu'ensuite le système optique (12) est amené jusqu'à proximité immédiate du point de brasage et que la précision de la position des bornes extérieures (3) des modules (4) par rapport aux plots de brasure (15) de la plaquette à circuits imprimés (16) est contrôlée et, si cela est nécessaire, est corrigée, qu'ensuite le système optique (2) est rétracté et que l'unité thermique de brasage (1) est abaissée jusqu'à ce que les bornes extérieures (3) du module (4) s'appliquent sur les plots de brasure de la plaquette à circuits imprimés (7), qu'ensuite le vide est supprimé de la pipette d'aspiration (5) et que cette dernière est légèrement soulevée et que simultanément au début de l'opération de brasage, de l'azote est projeté par soufflage depuis la pipette d'aspiration (5) sur la zone de brasage et qu'après l'opération de brasage, l'unité thermique de brasage (1) et la pipette d'aspiration (5) sont à nouveau amenées en la position finale.

2. Dispositif pour la mise en oeuvre du procédé suivant la revendication 1, caractérisé par le fait qu'une première unité linéaire (10) est accouplée par un arbre d'entraînement à vis pour l'exécution de déplacements verticaux, à un premier moteur pas-à-pas (8), qui pour sa part déplace verticalement par l'intermédiaire d'une colonne (13) qui guide frontalement un ressort de pression (14), une unité thermique de brasage (1) fixée à la première unité linéaire (10), que l'unité thermique de brasage (1) contient des étriers de brasage (6), qui sont disposés en carré et dont la température est réglée individuellement, qu'à une seconde unité linéaire (11) est fixée une pipette d'aspiration (5), qui est disposée de manière à être déplaçable verticalement à l'aide d'un second moteur pas-à-pas (9), entre les étriers de brasage de l'unité thermique de brasage (1), et qu'un système optique (12) pouvant être rétracté horizontalement est disposé latéralement sur l'unité thermique de brasage.
